# EUROPÄISCHE PATENTSCHRIFT

(11) **EP 2 940 731 B1**
(45) Veröffentlichungstag und Bekanntmachung des Hinweises auf die Patenterteilung: **25.12.2019**
(21) Anmeldenummer: 15162444.2
(22) Anmeldetag: 02.04.2015
(51) Int. Cl.: H01L 25/07, H01L 23/00, H01L 23/373, H01L 23/40, H01L 23/427, H01L 23/62

(54) **TRANSISTORANORDNUNG FÜR EINEN SPANNVERBAND UND SPANNVERBAND MIT ZUMINDEST EINER SOLCHEN TRANSISTORANORDNUNG**
TRANSISTOR ARRANGEMENT FOR AN ASSEMBLY UNDER PRESSURE AND ASSEMBLY UNDER PRESSURE HAVING AT LEAST ONE SUCH TRANSISTOR ARRANGEMENT
ARRANGEMENT INCLUANT AU MOINS UN TRANSISTOR POUR UN ENSEMBLE SOUS PRESSION ET ENSEMBLE SOUS PRESSION DOTÉ D'AU MOINS UN TEL ARRANGEMENT

(30) Priorität: 28.04.2014 DE 102014207927
(43) Veröffentlichungstag der Anmeldung: 04.11.2015
(73) Patentinhaber: Siemens Aktiengesellschaft, 80333 München (DE)
(72) Erfinder: Sahan, Benjamin, 90762 Fürth (DE); Stegmeier, Stefan, 81541 München (DE); Mitic, Gerhard, 81827 München (DE); Schremmer, Frank, 90768 Fürth (DE); Weidner, Karl, 81245 München (DE)

(56) Entgegenhaltungen:
- EP-A1- 1 318 545
- EP-A1- 2 019 429
- EP-A1- 2 560 203
- EP-A2- 2 388 817
- DE-A1-102004 018 477

## Beschreibung

Die Erfindung betrifft eine Transistoranordnung für einen Spannverband, mit einem ersten Träger, auf dem zumindest ein Transistorchip angeordnet ist, und mit einem zweiten Träger, der von zumindest einem Abstandshalter in einem Normalbetrieb der Transistoranordnung in einem vorbestimmten Abstand zu dem ersten Träger gehalten wird, wobei der Abstandshalter und der Transistorchip zwischen den beiden Trägern angeordnet sind. Die Erfindung betrifft ferner einen Spannverband mit zumindest einer solchen Transistoranordnung und einer Spanneinrichtung.

Das Umfeld der vorliegenden Erfindung betrifft die Sicherstellung einer leistungselektronischen Energiewandlung und eines leistungselektronischen Energietransportes, wie er beispielsweise im Bereich von Hochleistungsantrieben mit insbesondere mehr als 20 MW Leistung oder bei der Hochspannungs-Gleichstrom-Übertragung eine Rolle spielt. Die Hochspannungs-Gleichstrom-Übertragung (HGÜ) ist eine Technik für den verlustarmen Energietransport und somit ein Schlüssel für eine stärkere Einbindung erneuerbarer Energiequellen in ein Stromnetz. Heute kommen hier meist leistungselektronische Bauteile in Form von Thyristoren oder auch Bipolartransistoren mit isolierter Gate-Elektrode (IGBT) zum Einsatz. Thyristoren sind als sehr robuste Scheibenzellen ausgeführt und legieren in einem thermischen Fehlerfall dauerhaft und sicher durch. Da sie jedoch nicht aktiv abschaltbar sind, können Sie dynamischen die Anforderungen heutiger Netze nur schwer erfüllen. Daher kommen zunehmend Anlagen mit abschaltbaren Bauelementen, insb. IGBT zum Einsatz. Nach einem Fehler, beispielsweise einem Abschaltversager oder einem thermischen Fehlerfall, sind die IGBTs jedoch nicht sicher elektrisch leitfähig. Meist sind in industriellen IGBT-Modulen die Transistorchips mit Bonddrähten kontaktiert. Die Bonddraht-Technologie ist als Ausfallmechanismus jedoch insbesondere bei der Reihenschaltung von IGBTs, sowie in ähnlichen Abwandlungen wie sie beispielsweise einem modularen Multilevelumrichter vorkommen, problematisch. Im Fehlerfall kommt es außerdem beim Ablösen des Bonddrahtes zum Zünden eines Lichtbogens und in Folge ggf. zu einem Kollateralschaden in der Umgebung des IGBTs. Zur Vermeidung der Kollateralschäden im Augenblick des Transistorausfalls wird ein hoher Aufwand für eine Qualifizierung der IGBT-Module für solche Szenarien und für die Fertigung eines dann meist erforderlichen zusätzlichen Gehäuses betrieben.

Aus der EP 2 388 817 A2 ist ein Presspackmodul mit Leistungs-überlagerungsverbindung bekannt, bei dem zwischen zwei elektrisch leitfähigen Platten eine Schichtanordnung von Halbleiterelementen, dielektrischen Elementen und elektrischen Leitern vorgesehen ist. Dabei ist zudem zwischen einer der Platten und einer die Halbleiterelemente kontaktierenden leitfähigen Schicht eine Anordnung von einer oder mehreren Federelementen vorgesehen.

Aus der EP 1 318 545 A1 ist ein Leistungshalbleiter-Submodul bekannt, bei dem mehrere Halbleiterchips nebeneinander oberhalb einer Grundplatte angeordnet und durch Kontaktstempel mit einer Kraft beaufschlagt sind.

Die DE 10 2008 059 670 B3 offenbart einen mechanischen Kurzschließer, welcher mit dem Transistor parallel geschaltet wird, um in einem Fehlerfall einen IGBT-Umrichter weiter betreiben zu können. Die EP 098 9611 B1 offenbart eine Alternative auf Halbleiterebene, bei welcher eine Silberschicht auf einen IGBT aufgetragen wird, die im Kurzschlussfall des Transistors eine leitfähige Legierung zwischen dem im Chip vorhandenen Silizium und dem Silber bildet.

Die EP 2 544 229 A1 offenbart eine Technologie mit modulinternen Federkontakten, bei welchen sich oberhalb eines Transistorchips ein bei niedrigen Temperaturen schmelzendes Material befindet, welches in einem thermischen Fehlerfall schmilzt und durch den Federkontakt verdrängt wird, um einen elektrischen Druckkontakt zu schließen.

Es ist Aufgabe der vorliegenden Erfindung, eine sogenannte conduct-on-fail-Funktionalität, eine zuverlässige permanente elektrische Durchleitfähigkeit nach einem thermischen Fehlerfall, für einen Transistorchip zu erzielen und dabei in einem Normalbetrieb vor dem Fehlerfall eine Lebensdauer des Transistorchips nicht zu beeinträchtigen.

Diese Aufgabe wird von einer Transistoranordnung gemäß dem unabhängigen Patentanspruch sowie durch einen Spannverband mit solch einer Transistoranordnung gelöst.

Eine erfindungsgemäße Transistoranordnung für einen Spannverband umfasst einen ersten Träger, auf dem zumindest ein Transistorchip angeordnet ist, und einen zweiten Träger, der von zumindest einem Abstandshalter in einem Normalbetrieb der Transistoranordnung in einen vorbestimmten Abstand zu dem ersten Träger gehalten wird. Dabei sind der Abstandshalter und der Transistorchip zwischen den beiden Trägern angeordnet. Unter einem Normalbetrieb ist hier ein Betrieb vor einem thermischen Fehlerfall wie z.B. einer Explosion, einer schlagartigen Erhitzung und/oder Verdampfung von zumindest Teilen eines Transistorchips zu verstehen. Um eine conduct-on-fail-Funktionalität, eine zuverlässige permanente elektrische Durchleitfähigkeit nach einem thermischen Fehlerfall, für den Transistorchip zu erzielen und dabei in einem Normalbetrieb vor dem Fehlerfall eine Lebensdauer des Transistorchips nicht zu beeinträchtigen, besteht der zumindest eine Abstandshalter zumindest teilweise aus einem unter einem Wärmeeinfluss, insbesondere bei einer in dem thermischen Fehlerfall der Transistoranordnung im Bereich des Abstandshalters auftretenden Temperatur, erweichenden Material und ist in einer Ebene parallel zu den Haupterstreckungsrichtungen des ersten Trägers seitlich neben dem Transistorchip angeordnet. Ein Erweichen beinhaltet im Rahmen dieser Erfindung insbesondere auch ein Schmelzen.

Dadurch ist der Transistorchip im Normalbetrieb bei einem Druck auf die Träger druckfrei, da der Druck über den zumindest einen Abstandshalter geleitet wird. Der zumindest eine Abstandshalter verhindert also ein Drücken der beiden Träger auf den Transistorchip bei einem Beaufschlagen der Träger mit einem Druck im Normalbetrieb. In einem thermischen Fehlerfall jedoch entsteht eine Wärme und der Abstandshalter erweicht. Dadurch ist es möglich, die Transistoranordnung in einem Spannverband anzuordnen, in welchem, insbesondere dauerhaft, ein Druck auf die beiden Träger ausgeübt wird. Einerseits wird so im Normalbetrieb der Transistorchip ohne Druck betrieben. Andererseits wird in einem Fehlerbetrieb beziehungsweise in einem thermischen Fehlerfall über den, insbesondere dauerhaften, Druck auf die beiden Träger und ein Zusammendrücken der beiden Träger bei dem erweichenden Abstandshalter ein Durchlegieren des Transistorchips gefördert. Bei dem Durchlegieren des Transistorchips wird dieser durch ein Eindiffundieren eines Materials, beispielsweise Kupfer, in den Transistorchip dauerhaft leitend, so wie es für eine conduct-on-fail-Funktionalität des Transistorchips, also ein sicheres, dauerhaftes elektrisches Koppeln, bzw. ein Kurzschließen, zwischen einem Emitter und einem Kollektor des Transistorchips, erforderlich ist, ermöglicht.

Dadurch, dass die wesentlichen Elemente der Transistoranordnung zwischen den beiden Trägern angeordnet sind, können auch mehrere Transistoranordnungen in einfacher Weise aufeinander gestapelt werden und in einem Spannverband mit einem gemeinsamen Druck beaufschlagt werden. Der wesentliche Vorteil dieser stapelbaren und conduct-on-fail-fähigen Transistoranordnung liegt darin, dass in dem Normalbetrieb keine Druckbelastung auf den zumindest einen Transistorchip ausgeübt wird. Somit werden Transistorchipzerstörungen vermieden und es kann von einer höheren Zuverlässigkeit der Transistoranordnung ausgegangen werden. Ebenfalls können bruchanfällige Halbleiterchips, beispielsweise aus Silicium-Karbid, oder dünne Chips im Aufbau verwendet werden. Durch die Druckbeaufschlagung des Transistorchips im thermischen Fehlerfall, bei welchem der zweite Träger auf den Transistorchip pressbar ist, kann ebenfalls ein Durchlegieren des Transistorchips und damit der conduct-on-fail-Fall, sprich die sichere, dauerhafte Leitfähigkeit des Transistorchips erreicht werden. Dabei sind keine aufwendigen Lösungen erforderlich, und auch ein mechanischer Kurzschließer und ein Zusatzgehäuse, wie es der Stand der Technik erfordert, sind überflüssig. Durch Reduzierung dieser Komponenten beziehungsweise Materialien wird ebenfalls die Zuverlässigkeit der Transistoranordnung erhöht und die Kosten gesenkt. Die beschriebene Transistoranordnung kann zusätzlich über eine Vergrößerung der beiden Träger grundsätzlich auf das Aufnehmen beliebig vieler Transistorchips mit entsprechenden Abstandshaltern skaliert werden. Bedingt durch den einfachen Aufbau können nahezu beliebig viele der Transistoranordnungen in einem Spannverband aufeinander gestapelt werden. Dort ist dann zusätzlich zu einer Verspannung keine weitere Verschraubung notwendig. Überdies sind dabei thermische Übergangswiderstände zwischen den einzelnen Transistoranordnungen sehr klein. Zudem kann die beschriebene Transistoranordnung in einem Scheibenzellengehäuse realisiert werden, welches im Fall eines Gleichstromkurzschlusses eine hohe Stromfähigkeit ermöglicht. Somit können bei einer Verwendung der Transistoranordnung in einem Stromrichter externe Thyristoren wegfallen.

Auf einer Transistorchipkontaktfläche, insbesondere der Emitterseite, können daher spezielle Metalle und/oder Legierungen und/oder metallische Schichtsysteme mit unterschiedlichen Schmelztemperaturen aufgebracht sein. Somit wird im thermischen Fehlerfall das Durchlegieren des Transistorchips unterstützt, indem die Legierungen oder Metalle bei einer thermischen Überlast des Transistorchips aufschmelzen und in den Transistorchip eindiffundieren bzw. einen Kurzschluss bilden.

Auf dem ersten Träger können zudem spezielle Verbundwerkstoffe wie zum Beispiel Metalle mit pyrolytischen Graphiten oder gut leitende Keramiken wie zum Beispiel Aluminiumnitrit angeordnet sein, um in einem thermischen Fehlerfall die Temperatur schnell über den gesamten Träger zu verteilen. Der erste Träger kann auch ganz oder teilweise aus solchen Verbundwerkstoffen bestehen. Das hat den Vorteil, dass in dem thermischen Fehlerfall des Transistorchips die entstehende Wärme schnell zu dem zumindest einen Abstandshalter geleitet wird, sodass dieser schnell erweicht und somit ein schnelles Annähern der beiden Träger ermöglicht. Damit wird der Druck auf den Transistorchip schnell erhöht, was ein zügiges Durchlegieren des Transistorchips fördert.

In einer vorteilhaften Ausführungsform ist vorgesehen, dass der zweite Träger zumindest teilweise elektrisch leitfähig ist. Das hat den Vorteil, dass die elektrische Kontaktierung des Transistorchips über den zweiten Träger erfolgen kann, und zwar sowohl im Normalbetrieb als auch in einem auf den thermischen Fehlerfall folgenden Kurzschlussbetrieb mit einem durchlegierten, also dauerhaft leitfähigen Transistorchip.

Der zweite Träger kann auch an einer dem ersten Träger zugewandten Unterseite Noppen oder druckstempelartige Ausformungen haben, welche in dem Fehlerfall lokal den Druck auf den darunterliegenden Transistorchips in bestimmten Bereichen des Transistorchips erhöhen. Damit kann das Durchlegieren im Fehlerfall gezielt in den bestimmten Bereichen des Transistorchips gefördert werden.

In einer besonders vorteilhaften Ausführungsform ist vorgesehen, dass der Abstandshalter zumindest teilweise aus einem Material besteht, welches erst bei einer Temperatur oberhalb einer in dem thermischen Fehlerfall der Transistoranordnung auftretenden Temperatur, insbesondere bei mehr als 150°C oder bei mehr als 300°C, bevorzugt bei mehr als 500°C oder mehr als 1.000°C erweicht, insbesondere schmilzt, wobei es sich insbesondere um ein elektrisch leitfähiges Material, insbesondere um ein Metall, bevorzugt Kupfer, handelt. Das hat den Vorteil, dass eine geringfügige Erwärmung der Transistoranordnung in einem Normalbetrieb auftreten kann, ohne dass der Abstandshalter erweicht oder schmilzt und die beiden Träger sich annähern und in Folge die Lebensdauer des Transistorchips verringert wird. Erst bei einer für einen thermischen Fehlerfall charakteristischen Temperatur erfolgt also ein Erweichen des Abstandshalters, und in Folge bei einer Druckbeaufschlagung ein Annähern der beiden Träger.

Die Abstandshalter können auch aus Lotwerkstoffen oder sogenannten Heatspring-Materialien gefertigt sein. Letzteres hat den Vorteil, dass sie in der Fertigung durch ein ledigliches Andrücken an den zweiten Träger mit diesem verlötet werden können.

In einer weiteren Ausführungsform ist vorgesehen, dass der Abstandshalter elektrisch leitfähig ist sowie elektrisch mit dem zweiten Träger und einer Kontaktfläche, insbesondere einem Emitter, des Transistorchips gekoppelt ist. Der Abstandshalter ist dabei von dem ersten Träger elektrisch isoliert, wenn der Transistorchip in einem nicht leitenden Zustand ist. Der Abstandshalter kann dabei aus einem oder mehreren Metallen, zum Beispiel niedrigschmelzendem Indium oder Zinn oder Kupfer, Metallverbindungen, zum Beispiel Loten, und anderen elektrisch leitfähigen Verbindungen oder deren Kombinationen bestehen. Das hat den Vorteil, dass die Anpresskraft in einem Spannverband, welche notwendig ist, um die conduct-on-fail-Funktionalität zu erreichen, verringert werden kann, da der Transistorchip bereits im Normalbetrieb eine elektrische Kopplung an den zweiten Träger aufweist.

Der Abstandshalter kann hier auch zweiteilig mit einem leicht zu erweichenden elektrisch leitenden ersten Material und einem höherschmelzenden, weniger leicht als das erste Material erweichenden, elektrisch gut leitenden zweiten Material ausgeführt werden. Bei dem zweiten Material kann es sich zum Beispiel um Kupfer oder Aluminium handeln. Hierdurch kann in der Regel eine höhere elektrische Leitfähigkeit erreicht werden als bei einer einteiligen Ausführung aus dem ersten Material.

In einer weiteren Ausführungsform ist vorgesehen, dass der Abstandshalter ein Federelement aus einem elektrisch leitfähigen Material und ein Stützelement aus einem elektrisch nicht leitenden Material umfasst. Bei dem nicht leitenden Material kann es sich beispielsweise um ein Polymer, ein Siloxan, oder Verbindungen von Polymeren und Siloxanen handeln. Das hat den Vorteil, dass die Erweichungstemperatur des Abstandshalters über die Materialwahl frei eingestellt werden kann, ohne dabei auf eine elektrische Leitfähigkeit des Materials achten zu müssen.

In einer besonders vorteilhaften Ausführungsform ist vorgesehen, dass der zumindest eine Transistorchip ein Transistorchip eines Bipolartransistors mit isolierter Gateelektrode (IGBT) ist und/oder eine Kollektorseite des Transistorchips an dem ersten Träger angeordnet und mit diesem bzw. einer Leiterbahn desselben elektrisch kontaktiert ist und/oder eine Emitterseite des Transistorchips, insbesondere planar, beispielsweise mittels der Siemens Planar Interconnect-Technik (SiPLIT), mit einem Leiter, der elektrisch mit dem Abstandshalter gekoppelt ist, elektrisch kontaktiert ist. Die Emitterseite des Transistorchips kann dabei insbesondere über Bonddrähte elektrisch an den Abstandshalter gekoppelt sein. Das hat den Vorteil, dass die erforderliche Anpresskraft in einem Spannverband, welche erforderlich ist, um die conduct-on-fail-Funktionalität im thermischen Fehlerfall zu erreichen, in Verbindung mit einem elektrisch leitfähigen Abstandshalter und einem zumindest teilweise leitenden zweiten Träger erheblich reduziert werden kann, da die Träger bereits ohne den Spannverband eine elektrische Kopplung mit dem Transistorchip aufweisen.

In einer weiteren Ausführungsform ist vorgesehen, dass zwischen einer von dem ersten Träger abgewandten Kontaktfläche, insbesondere einem Emitter, des Transistorchips und dem zweiten Träger ein, insbesondere elektrisch leitfähiges, flexibles oder flüssig-viskoses Füllmaterial, insbesondere ein Metallschwamm oder eine Wärmeleitpaste oder ein Polymer, angeordnet ist. Hierbei kann es sich beispielsweise um Aluminiumkontaktpasten oder besonders wärmeleitfähige Polymere handeln, welche im thermischen Fehlerfall dann durch eine Druckbeaufschlagung verdrängt werden. Das Füllmaterial ist hier insbesondere so weich, dass ein Druck, der erforderlich ist um das Füllmaterial zu verdrängen, keinen der Träger und/oder den Transistorchip beschädigt. Das hat den Vorteil, dass eine Wärme von dem Transistorchip besonders gut auf den zweiten Träger übertragen werden kann, sodass die Transistoranordnung besser gekühlt werden kann. Insbesondere kann so eine Kühleinrichtung, welche thermisch an den zweiten Träger gekoppelt ist, besonders effizient zur Kühlung des Transistorchips beitragen.

In einer weiteren Ausführungsform ist vorgesehen, dass zwischen einer von dem ersten Träger abgewandten Kontaktfläche, insbesondere einem Emitter, des Transistorchips und dem zweiten Träger ein Ausdehnungselement angeordnet ist. Insbesondere kann das Ausdehnungselement an dem zweiten Träger angeordnet sein. Das Ausdehnungselement verfügt über einen Ausdehnungskoeffizienten, welcher insbesondere den Ausdehnungskoeffizienten des Abstandshalters und/oder der Träger und/oder weiterer Bauteile der Transistoranordnung übertrifft. Das Ausdehnungselement kann alternativ oder ergänzend zumindest teilweise aus einer Formgedächtnislegierung, beispielsweise in Form einer Einwege- oder Zweiwegeformgedächtnislegierung, oder einem Bimetall, zum Beispiel in einer Schnappschussausführung welche bei einer Erwärmung in eine andere Form schnappt, bestehen. Entscheidend ist, dass das Ausdehnungselement in dem thermischen Fehlerfall einen Druck zwischen dem zweiten Träger und der von dem ersten Träger abgewandten Kontaktfläche des Transistorchips aufbaut. Das hat den Vorteil, dass, wenn die Transistorordnung mehr als einen Transistorchip umfasst und der thermische Fehlerfall auf einen Transistorchip begrenzt ist, so über eine lokale Beaufschlagung mit Druck ein Durchlegieren eines einzelnen Transistorchips erreicht werden kann. Es kann also z.B. ein einzelner Chip durchlegieren, ohne dass dafür ein Abstandshalter schmelzen muss.

Die Erfindung betrifft auch einen Spannverband mit zumindest einer solchen Transistoranordnung, wobei die Träger der Transistoranordnung durch eine Spanneinrichtung unter Druckbeaufschlagung kraftschlüssig miteinander verbunden sind. Das hat den Vorteil, dass der für die conduct-on-fail-Funktionalität erforderliche Druck zur Verfügung gestellt wird und gleichzeitig in dem Normalbetrieb die Transistorchips der Transistoranordnungen druckfrei verbleiben. Auch können so im Wesentlichen beliebig viele Transistoranordnungen aufeinander gestapelt werden, wobei hier keine Verschraubung erforderlich ist. Zudem sind dann thermische Übergangswiderstände zwischen den einzelnen Transistoranordnungen sehr gering.

Hierbei kann vorgesehen sein, dass die Träger auf einer Führungsschiene angebracht werden, sodass diese sich lediglich parallel zueinander bewegen können. Das hat den Vorteil, dass ein Verkippen und entsprechend gegebenenfalls ein Verkanten der Träger im thermischen Störfall vermieden werden.

In einer vorteilhaften Ausführungsform des Spannverbandes ist vorgesehen, dass dieser zumindest zwei Transistoranordnungen umfasst, deren Träger im Wesentlichen parallel zueinander angeordnet sind und zwischen welchen eine Kühleinrichtung angeordnet ist. Das hat den Vorteil, dass die Transistoranordnungen so besonders effizient gekühlt werden können, da eine Kühleinrichtung jeweils zwei Transistoranordnungen kühlen kann und so besonders einfach und unabhängig von der Anzahl der Transistorchips in den jeweiligen Transistoranordnungen gekühlt werden kann.

Weitere Merkmale der Erfindung ergeben sich aus den Ansprüchen, den Figuren und der Figurenbeschreibung. Alle vorstehend in der Beschreibung genannten Merkmale und Merkmalskombinationen sowie nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder aber in Alleinstellung verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind. Ausführungsbeispiele der Erfindung werden nachfolgend anhand schematischer Zeichnungen erläutert.

Es zeigen:
- FIG 1: eine schematische Schnittdarstellung eines ersten Ausführungsbeispiels einer erfindungsgemäßen Spannvorrichtung mit einer Transistoranordnung in einem Normalbetrieb;
- FIG 2: eine schematische Schnittdarstellung des ersten Ausführungsbeispiels eines Spannverbandes nach einem thermischen Fehlerfall;
- FIG 3: eine schematische Schnittdarstellung eines zweiten Ausführungsbeispiels eines Spannverbandes in einem Normalbetrieb; sowie
- FIG 4: eine schematische Schnittdarstellung eines dritten Ausführungsbeispiels eines Spannverbands in einem Normalbetrieb.

Gleiche oder funktionsgleiche Elemente werden in den Figuren mit den gleichen Bezugszeichen versehen.

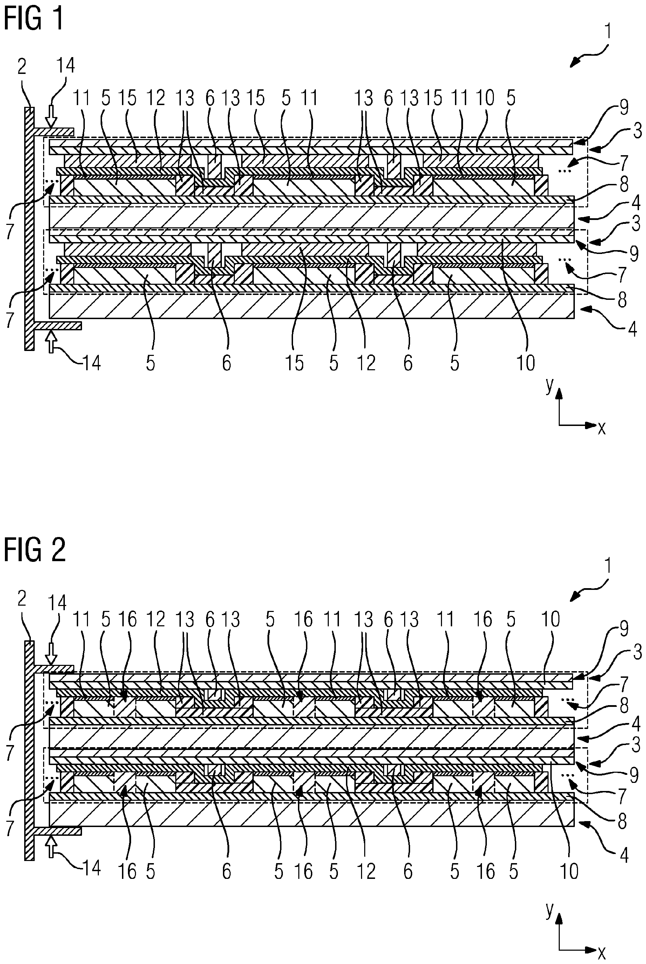

FIG 1 zeigt eine schematische Schnittdarstellung durch ein erstes Ausführungsbeispiel eines erfindungsgemäßen Spannverbandes in einem Normalbetrieb. Der Spannverband 1 verfügt hier über eine Spanneinrichtung 2, welche im gezeigten Beispiel zwei Transistoranordnungen 3 sowie zwei Kühleinrichtungen 4 zusammenspannt. Grundsätzlich können hier beliebig viele Transistoranordnungen 3 mit oder ohne Kühleinrichtungen 4 zusammengespannt werden. Die Transistoranordnungen 3 und Kühleinrichtungen 4 sind hier in einer y-Richtung aufeinander gestapelt und erstrecken sich hauptsächlich in einer Ebene entlang einer x-Richtung und einer aus der Zeichenebene hinausweisenden z-Richtung. Jede der Transistoranordnungen 3 ist hier mit jeweils z.B. drei einzelnen, in x-Richtung voneinander beabstandeten Transistorchips 5 und z.B. zwei Abstandshaltern 6 zwischen den Transistorchips 5 dargestellt, wobei Punkte 7 in x-Richtung neben den Transistoranordnungen 3 vorliegend andeuten, dass sich die Transistoranordnungen 3 mit einem sich wiederholenden Aufbau, also mit weiteren Transistorchips 5 und Abstandshaltern 6 in positiver und negativer x-Richtung erstrecken.

Da die Transistoranordnungen 3 identisch aufgebaut sind, wird hier lediglich eine der gezeigten zwei Transistoranordnungen 3 ausführlich im Detail beschrieben. Eine Transistoranordnung 3 umfasst im gezeigten Beispiel einen ersten, in negativer y-Richtung gelegenen unteren Träger 8 sowie einen oberen, in positiver y-Richtung angeordneten zweiten Träger 9, welcher vorliegend eine elektrisch leitfähige Schicht 10 umfasst. Die Transistorchips sind vorliegend auf dem unteren ersten Träger 8 angebracht und verfügen auf ihrer jeweiligen Oberseite, welche dem oberen zweiten Träger 9 zugewandt ist, je über eine Metallisierung 11. Bei dieser Metallisierung 11 kann es sich z.B. um Aluminium, Silizium oder Kupfer oder auch um eine Mischung z.B. dieser Metalle handeln. Die Oberseite der jeweiligen Transistorchips 5 ist vorliegend die Emitterseite, beispielsweise eines Transistorchips eines IGBT-Transistors. Dieser Emitter ist vorliegend planar mit einer Leiterbahn 12 aus z.B. Kupfer ankontaktiert. Die Leiterbahn 12 erstreckt sich seitlich, also in die x-Richtungen über die Transistorchips 5 hinweg, im gezeigten Beispiel durch die gesamte Erstreckung der Transistoranordnung 3 in x-Richtung hindurch. Damit werden hier durch die Leiterbahn 12 die Emitterseiten beziehungsweise die Metallisierungen 11 aller, vorliegend drei, Transistorchips 5 elektrisch miteinander gekoppelt. In den Bereichen zwischen den einzelnen voneinander beabstandeten Transistorchips 5 ist die Leiterbahn 12 mit jeweiligen Isolatoren 13 von dem unteren ersten Träger 8 elektrisch isoliert.

Seitlich der Transistorchips 5, also in einer x-Richtung zwischen den Transistorchips 5, sowie in einer y-Richtung zwischen dem Leiter 12 und dem oberen zweiten Träger 9 sind im gezeigten Beispiel die beispielsweise schmelzbaren, zum Beispiel leitfähigen Abstandshalter 6 angeordnet. Diese stützen den oberen zweiten Träger 9 auf dem Leiter 12 beziehungsweise über den Leiter 12 und die jeweiligen Isolatoren 13 auf dem unteren ersten Träger 8 ab, sodass der über die Spannvorrichtung 2 beaufschlagte Druck, welcher durch die Pfeile 14 repräsentiert ist, die beiden Träger 8, 9 nicht aufeinander zu bewegt. Da die Abstandshalter 6 seitlich, in x-Richtung zwischen den Transistorchips 5, angeordnet sind, werden diese in dem gezeigten Normalbetrieb nicht mit einem Druck durch die Spannvorrichtung 2 beaufschlagt.

Die Abstandshalter 6 sind dabei elektrisch lediglich über die Transistorchips 5 mit dem unteren ersten Träger 8 beziehungsweise der Kollektorseite der Transistorchips 5 elektrisch kontaktierbar. Oberhalb der Oberseite der Transistorchips 5, also über der Metallisierung 11 der Transistorchips 5 in y-Richtung, ist zwischen der Leiterbahn 12 und dem oberen zweiten Träger 9 in diesem Beispiel jeweils ein Füllmaterial 15, vorliegend eine elektrisch leitfähige Wärmeleitpaste, aufgebracht, sodass der Transistorchip 5 zusätzlich zur elektrischen und thermischen Kopplung über die Abstandshalter 6 noch Wärme und Strom an den zweiten Träger 9 abführen kann, ohne dass dabei die Transistorchips 5 im Spannverband 1 mechanisch belastet würden. Die Transistoranordnungen 3 sind vorliegend abwechselnd mit den Kühleinrichtungen 4 in Schichten angeordnet. Die Kühleinrichtung 4 kann hier beispielsweise ein Aluminiumkühler, welcher z.B. mit Wasser durchströmt wird, sein.

In FIG 2 ist der Spannverband von FIG 1 nach einem thermischen Fehlerfall dargestellt. Darstellung und vorhandene Elemente sind hier zu FIG 1 identisch, es hat lediglich die in dem thermischen Fehlerfall auftretende Hitze in Kombination mit dem durch die Spanneinrichtung 2 ausgeübten Druck auf die Transistoranordnungen 3 zu einem Verschieben der beiden Träger 8, 9 relativ zueinander geführt.

In dem thermischen Fehlerfall erwärmt sich die Transistoranordnung 3 deutlich und erreicht Temperaturen, die beispielsweise 150°C deutlich überschreiten. Dabei beginnen die Abstandshalter 6 zu erweichen oder zu schmelzen, wodurch die von den Pfeilen 14 repräsentierte Druckbeaufschlagung durch die Spanneinrichtung 2 auf die Transistoranordnungen 3 zu einem Verformen der Abstandshalter 6 führt. Als Folge nähern die beiden Träger 8, 9 sich an. Dabei wird das Füllmaterial 15 (FIG 1) nach außen aus der jeweiligen Transistoranordnung verdrängt und die Abstandshalter 6 derart zusammengepresst beziehungsweise verformt, dass die leitfähige Schicht 10 des oberen zweiten Trägers 9 vorliegend direkt mit der Leiterbahn 12 direkt in mechanischen und elektrischen Kontakt kommt. Dabei wird ein Druck auf die Transistorchips 5 ausgeübt, welcher ein Durchlegieren der Transistorchips 5 beispielsweise in einem mittleren Bereich 16 der Transistorchips 5 fördert.

Somit werden nach einem thermischen Fehlerfall mittelbar durch die im Fehlerfall entstehende Hitze und unmittelbar durch einen von außen vorliegend über die Spanneinrichtung 2 beaufschlagten Druck der erste Träger 8 und der zweite Träger 9 dauerhaft elektrisch miteinander gekoppelt. Es können hier z.B. an der Unterseite des oberen zweiten Trägers 9 auch Noppen oder druckstempelartige Ausformungen vorgesehen sein, welche lokal den Druck auf darunterliegende Transistorchips 5 in bestimmten Bereichen des Transistorchips 5 erhöhen. Die IGBT-Transistoren 5 können planar beispielsweise über die SiPLIT-Technik gefertigt sein.

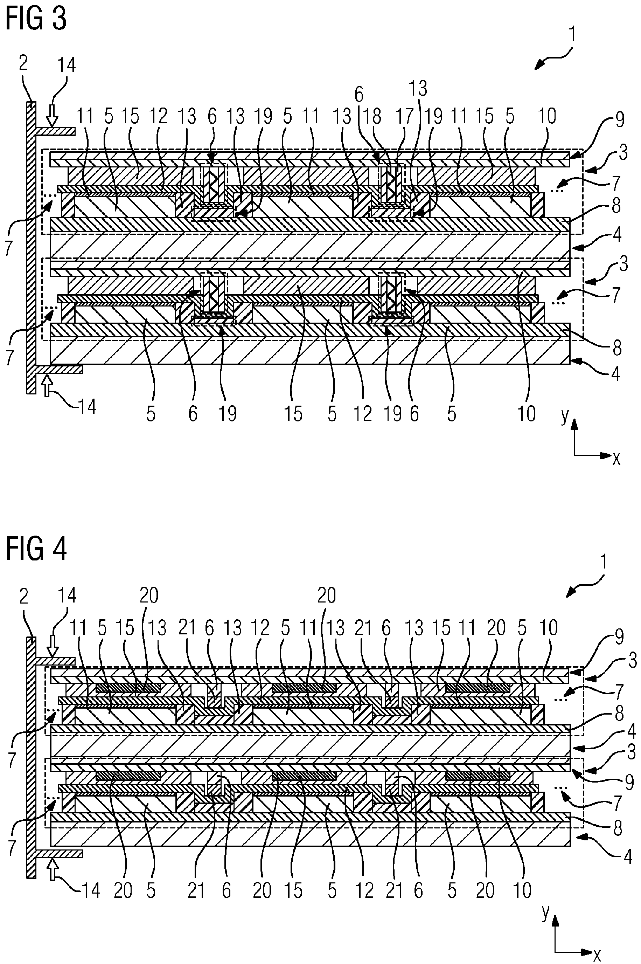

In FIG 3 ist ein zweites Ausführungsbeispiel eines Spannverbands 1 in einer schematischen Schnittansicht in einem Normalbetrieb dargestellt. Von dem in FIG 1 gezeigten Ausführungsbeispiel unterscheidet sich der vorliegende Spannverband 1 in der Ausführung der Abstandshalter 6. Diese umfassen vorliegend ein Stützelement 17 aus einem nicht leitenden Material wie beispielsweise einem Polymer oder einem Siloxan oder einem Materialverbund, welcher beispielsweise bei 170°C erweicht oder flüssig wird. Der Abstandshalter umfasst weiterhin ein elektrisch leitendes Federelement 18, welches vorliegend als metallische Feder ausgeführt ist und elektrisch sowohl mit der Leiterbahn 12 als auch mit der leitfähigen Schicht 10 des oberen zweiten Trägers 9 kontaktiert ist. In dem thermischen Fehlerfall erweichen oder schmelzen die Stützelemente 17, und die Spanneinrichtung 2 drückt das Federelement 18 zusammen, sodass das Durchlegieren der Transistorchips gefördert wird.

Überdies sind im vorliegenden Fall unterhalb der Abstandshalter 6, also in negativer y-Richtung, Bereiche 19 der Isolation 13 aus einem Metall mit pyrolytischen Graphiten und/oder Keramiken, z.B. als Plättchen aus Aluminiumnitrit, ausgeführt, um eine Wärme besser von dem ersten Träger 8 zu dem Abstandshalter 6 hin zu leiten. Auch der erste Träger 8 kann zur besseren Wärmeverteilung ein solches Material umfassen, sodass die Hitze eines durchbrennenden Transistorchips 5 im thermischen Fehlerfall sich gut in der Transistoranordnung 3 verteilt und besser abgeführt werden kann.

In FIG 4 ist eine schematische Schnittdarstellung eines dritten Ausführungsbeispiels eines Spannverbandes dargestellt. Von dem in FIG 1 dargestellten Ausführungsbeispiel unterscheidet sich das gezeigte Ausführungsbeispiel einerseits dadurch, dass hier jeweils oberhalb der Transistorchips 5 im gezeigten Beispiel zusätzlich zum Füllmaterial 15 noch ein jeweiliges Ausdehnungselement 20 zwischen dem zweiten Träger 9 und der Leiterbahn 12 angeordnet ist. Diese Ausdehnungselemente 20 verformen sich hier bei einem Erwärmen stärker als die sie umgebenden Bauteile, sodass dann zusätzlich zu dem Druck, welcher über die Spanneinrichtung 2 auf die Transistoranordnung 3 ausgeübt wird, durch ein Verformen eines jeweiligen Ausdehnelements 20 aufgrund einer lokalen Wärmeeinwirkung noch ein lokaler zusätzlicher Druck auf den unter dem jeweiligen Ausdehnungselement 20 liegenden Transistorchip 5 ausgeübt wird. Dies kann durch einen im Vergleich zu der Umgebung des Ausdehnungselements 20 erhöhten thermischen Ausdehnungskoeffizienten erzielt werden oder durch Verwenden eines Bimetalls oder eines Formgedächtnismaterials, welche sich jeweils bei einer Erwärmung verformen. Damit können auch einzelne Transistorchips 5 mit einem Druck beaufschlagt werden, welcher ein Durchlegieren, also ein Elektrisch-Leitfähig-Werden des jeweiligen unter dem Ausdehnungselement 20 liegenden Transistorchips 5 begünstigt.

Die Abstandshalter 6 sind im gezeigten Beispiel zudem in einer Vertiefung der Leiterbahn 12 zwischen den Transistorchips 5 angeordnet, aus welcher sie in der y-Richtung hervorragen, um so den zweiten Träger 9 von der Leiterbahn 12 zu beabstanden und einen auf den Träger 12 wirkenden Druck aufzunehmen. Dabei sind die Träger 6 im gezeigten Beispiel in einem unteren, in negativer y-Richtung gelegenen, Bereich 21, welcher nicht aus der Aussparung hervorragt, aus einem im thermischen Fehlerfall nicht schmelzenden, besonders gut leitfähigen Material, beispielsweise einem Metall wie Kupfer, gefertigt. Das hat den Vorteil, dass so auch im Normalbetrieb die elektrische Kopplung zwischen dem Leiter 12 und dem leitenden Bereich 10 des zweiten Trägers 9 verbessert werden kann, da niederschmelzende Legierungen oder Metalle oder sonstige Materialien im Allgemeinen einen z.B. im Vergleich zu Kupfer beträchtlichen elektrischen Widerstand aufweisen. Somit weist im gezeigten Beispiel im Normalbetrieb nur ein weniger langer Abschnitt des Abstandshalters 6 eine verhältnismäßig schlechte elektrische Leitfähigkeit auf und nur geringe elektrische Verluste entstehen.

Es kann auch vorgesehen sein, die Leiterbahn 12, welche im gezeigten Beispiel ja die Oberseiten sämtlicher Transistorchips 5 mit sämtlichen Abstandshaltern 6 elektrisch koppelt, zu unterbrechen, und lediglich die Transistorchips 5 planar mit einer jeweiligen einzelnen Leiterbahn 12 zu versehen und entsprechend die Abstandshalter 6 mit anderen Mitteln, beispielsweise Bonddrähten, an die jeweilige Leiterbahnen 12 der Transistorchips 5 elektrisch zu koppeln. Dies könnte beispielsweise erfolgen, indem zwischen den Abstandshaltern 6 und den darunter liegenden, jeweiligen Isolierungen 13 eine Metallschicht angebracht ist, welche über Bonddrähte mit den Leiterbahnen 12 der jeweiligen Transistorchips 5 elektrisch verbunden ist.

## Patentansprüche

1. Transistoranordnung (3) für einen Spannverband (1), mit einem ersten Träger (8), auf dem zumindest ein Transistorchip (5) angeordnet ist, und mit einem zweiten Träger (9), der von zumindest einem Abstandshalter (6) in einem Normalbetrieb der Transistoranordnung (3), welcher vor einem thermischen Fehlerfall stattfindet und in dem das Material des Abstandshalters (6) steif gegen Verformung ist, in einem vorbestimmten Abstand zu dem ersten Träger (8) gehalten wird, wobei der Abstandshalter (6) und der Transistorchip (5) zwischen den beiden Trägern (8, 9) angeordnet sind,
**dadurch gekennzeichnet, dass**
der zumindest eine Abstandshalter (6) zumindest teilweise aus einem unter einem in dem und durch den thermischen Fehlerfall auftretenden Wärmeeinfluss und der dabei im Bereich des Abstandshalters (6) auftretenden Temperatur erweichenden Material besteht und in einer Ebene des ersten Trägers (8) neben dem Transistorchip (5) angeordnet ist, wodurch der Transistorchip (5) im Normalbetrieb bei einem Druck auf die Träger (8, 9) druckfrei ist.

2. Transistoranordnung (3) nach Anspruch 1,
**dadurch gekennzeichnet, dass**
der zweite Träger (9) zumindest teilweise elektrisch leitfähig ist.

3. Transistoranordnung (3) nach einem der vorhergehenden Ansprüche,
**dadurch gekennzeichnet, dass**
der Abstandshalter (6) teilweise aus einem Material, besteht, welches erst bei einer Temperatur oberhalb einer in einem thermischen Fehlerfall der Transistoranordnung (3) auftretenden Temperatur, bei mehr als 150°C oder mehr als 300°C, oder bei mehr als 500°C oder mehr als 1000°C, erweicht.

4. Transistoranordnung (3) nach einem der vorhergehenden Ansprüche,
**dadurch gekennzeichnet, dass**
der Abstandshalter (6) elektrisch leitfähig und elektrisch mit dem zweiten Träger (9) sowie mit einer Kontaktfläche des Transistorchips (5) gekoppelt ist, wobei der Abstandshalter (6) wenn der Transistorchip (5) in einem nichtleitenden Zustand ist von dem ersten Träger (8) elektrisch isoliert ist.

5. Transistoranordnung (3) nach einem der vorhergehenden Ansprüche,
**dadurch gekennzeichnet, dass**
der Abstandshalter (6) ein Federelement (18) aus einem elektrisch leitfähigen Material und ein Stützelement (17) aus einem elektrisch nichtleitenden Material umfasst.

6. Transistoranordnung (3) nach einem der vorhergehenden Ansprüche,
**dadurch gekennzeichnet, dass**
der zumindest eine Transistorchip (5) ein Transistorchip eines Bipolartransistors mit isolierter Gate-Elektrode (IGBT) ist und/oder eine Kollektorseite des Transistorchips (5) an dem ersten Träger (8) angeordnet und mit diesem elektrisch gekoppelt ist und/oder eine Emitterseite des Transistorchips (5) mit einem Leiter, der elektrisch mit dem Abstandshalter (6) gekoppelt ist, elektrisch gekoppelt ist.

7. Transistoranordnung (3) nach einem der vorhergehenden Ansprüche,
**dadurch gekennzeichnet, dass**
zwischen einer von dem ersten Träger (8) abgewandten Kontaktfläche des Transistorchips (5) und dem zweiten Träger (9) ein flexibles oder flüssig viskoses Füllmaterial (15) angeordnet ist.

8. Transistoranordnung (3) nach einem der vorhergehenden Ansprüche,
**dadurch gekennzeichnet, dass**
zwischen einer von dem ersten Träger (8) abgewandten Kontaktfläche des Transistorchips (5) und dem zweiten Träger (9) ein Ausdehnungselement (20) angeordnet ist, mit einem Ausdehnungskoeffizienten welcher den Ausdehnungskoeffizienten des Abstandshalters (6) und/oder der Träger (8, 9) und/oder weiterer Bauteile der Transistoranordnung (3) übertrifft.

9. Spannverband (1) mit zumindest einer Transistoranordnung (3) nach einem der vorhergehenden Ansprüche, wobei die Träger (8, 9) der Transistoranordnung (3) durch eine Spanneinrichtung (2) unter Druckbeaufschlagung kraftschlüssig miteinander verbunden sind.

10. Spannverband (1) nach Anspruch 9 mit zumindest zwei Transistoranordnungen (3), deren Träger (8, 9) im Wesentlichen parallel zueinander angeordnet sind und zwischen welchen eine Kühleinrichtung (4) angeordnet ist.

## Claims

1. Transistor arrangement (3) for a tensioning assembly (1), comprising a first carrier (8), on which at least one transistor chip (5) is arranged, and comprising a second carrier (9), which is held at a predetermined distance from the first carrier (8) by at least one spacer (6) in a normal operation of the transistor arrangement (3), which occurs before a case of a thermal fault and in which the material of the spacer (6) is resistant to deformation, wherein the spacer (6) and the transistor chip (5) are arranged between the two carriers (8, 9),
**characterized in that**
the at least one spacer (6) at least partly consists of a material that softens under the influence of heat arising in the case of a thermal fault and as a result thereof and at the temperature arising in this case in the region of the spacer (6) and is arranged in a plane of the first carrier (8) alongside the transistor chip (5), as a result of which the transistor chip (5) is unpressurized during normal operation in the case of a pressure on the carriers (8, 9).

2. Transistor arrangement (3) according to Claim 1,
**characterized in that**
the second carrier (9) is at least partly electrically conductive.

3. Transistor arrangement (3) according to either of the preceding claims,
**characterized in that**
the spacer (6) partly consists of a material that softens only at a temperature above a temperature arising in the case of a thermal fault of the transistor arrangement (3), and more than 150°C or more than 300°C, or at more than 500°C or more than 1000°C.

4. Transistor arrangement (3) according to one of the preceding claims,
**characterized in that**
the spacer (6) is electrically conductively and electrically coupled to the second carrier (9) and also to a contact face of the transistor chip (5), wherein the spacer (6) is electrically insulated from the first carrier (8) when the transistor chip (5) is in a non-conductive state.

5. Transistor arrangement (3) according to one of the preceding claims,
**characterized in that**
the spacer (6) comprises a spring element (18) made of an electrically conductive material and a support element (17) made of an electrically non-conductive material.

6. Transistor arrangement (3) according to one of the preceding claims,
**characterized in that**
the at least one transistor chip (5) is a transistor chip of an insulated-gate bipolar transistor (IGBT) and/or a collector side of the transistor chip (5) is arranged on the first carrier (8) and is electrically coupled thereto and/or an emitter side of the transistor chip (5) is electrically coupled to a conductor, which is electrically coupled to the spacer (6).

7. Transistor arrangement (3) according to one of the preceding claims,
**characterized in that**
a flexible or liquid-viscous filling material (15) is arranged between a contact face of the transistor chip (5), said contact face facing away from the first carrier (8), and the second carrier (9).

8. Transistor arrangement (3) according to one of the preceding claims,
**characterized in that**
an expansion element (20) is arranged between a contact face of the transistor chip (5), said contact face facing away from the first carrier (8), and the second carrier (9), said expansion element having an expansion coefficient that exceeds the expansion coefficients of the spacer (6) and/or of the carriers (8, 9) and/or of further components of the transistor arrangement (3).

9. Tensioning assembly (1) comprising at least one transistor arrangement (3) according to one of the preceding claims, wherein the carriers (8, 9) of the transistor arrangement (3) are connected to one another in a force-fitting manner by way of a tensioning device (2) under application of pressure.

10. Tensioning assembly (1) according to Claim 9 comprising at least two transistor arrangements (3), the carriers (8, 9) of which are arranged substantially parallel to one another and between which a cooling device (4) is arranged.

## Revendications

1. Arrangement de transistor (3) pour un ensemble sous pression (1), comprenant un premier support (8) sur lequel au moins une puce de transistor (5) est disposée, et comprenant un deuxième support (9) qui est maintenu à une distance prédéterminée du premier support (8) par au moins un écarteur (6) dans un fonctionnement normal de l'arrangement de transistor (3) qui a lieu avant un défaut thermique et dans lequel le matériau de l'écarteur (6) est rigide contre la déformation, dans lequel l'écarteur (6) et la puce de transistor (5) sont disposés entre les deux supports (8, 9),
**caractérisé en ce que**
l'au moins un écarteur (6) est composé au moins partiellement d'un matériau ramollissant sous une influence thermique se produisant dans et par le défaut thermique et à la température se produisant alors au niveau de l'écarteur (6) et est disposé dans un plan du premier support (8) près de la puce de transistor (5), ce par quoi la puce de transistor (5) est exempte de pression en fonctionnement normal lors d'une pression sur les supports (8, 9).

2. Arrangement de transistor (3) selon la revendication 1,
**caractérisé en ce que** le
deuxième support (9) est au moins partiellement conducteur électrique.

3. Arrangement de transistor (3) selon l'une des revendications précédentes, **caractérisé en ce que** l'écarteur (6) est composé partiellement d'un matériau ramollissant uniquement à une température supérieure à une température se produisant dans un défaut thermique de l'arrangement de transistor (3), à plus de 150°C ou plus de 300°C, ou à plus de 500°C ou plus de 1000°C.

4. Arrangement de transistor (3) selon l'une des revendications précédentes, **caractérisé en ce que** l'écarteur (6) est conducteur électrique et couplé électriquement au deuxième support (9) ainsi qu'à une surface de contact de la puce de transistor (5), dans lequel l'écarteur (6), lorsque la puce de transistor (5) est dans un état non conducteur, est isolé électriquement du premier support (8).

5. Arrangement de transistor (3) selon l'une des revendications précédentes, **caractérisé en ce que** l'écarteur (6) comprend un élément de ressort (18) dans un matériau conducteur électrique et un élément d'appui (17) dans un matériau non conducteur électrique.

6. Arrangement de transistor (3) selon l'une des revendications précédentes, **caractérisé en ce que** l'au moins une puce de transistor (5) est une puce de transistor d'un transistor bipolaire avec électrode de grille isolée (IGBT) et/ou un côté collecteur de la puce de transistor (5) est disposé sur le premier support (8) et couplé électriquement à celui-ci et/ou un côté émetteur de la puce de transistor (5) est couplé électriquement à un conducteur qui est couplé électriquement à l'écarteur (6).

7. Arrangement de transistor (3) selon l'une des revendications précédentes, **caractérisé en ce qu'**un matériau de remplissage (15) visqueux flexible ou liquide est disposé entre une surface de contact de la puce de transistor (5) détournée du premier support (8) et le deuxième support (9).

8. Arrangement de transistor (3) selon l'une des revendications précédentes, **caractérisé en ce qu'**un élément de dilatation (20) est disposé entre une surface de contact de la puce de transistor (5) détournée du premier support (8) et le deuxième support (9), avec un coefficient de dilatation qui est supérieur au coefficient de dilatation de l'écarteur (6) et/ou des supports (8, 9) et/ou d'autres composants de l'arrangement de transistor (3).

9. Ensemble sous pression (1) comprenant au moins un arrangement de transistor (3) selon l'une des revendications précédentes, dans lequel les supports (8, 9) de l'arrangement de transistor (3) sont reliés entre eux par adhérence de forces par un dispositif de pression (2) par apport de pression.

10. Ensemble sous pression (1) selon la revendication 9 comprenant au moins deux agencements de transistor (3) dont les supports (8, 9) sont disposés essentiellement parallèles entre eux et entre lesquels est disposé un dispositif de refroidissement (4).
